(19) Europäisches Patentamt
European Patent Office
Office européen des brevets

(11) **EP 3 413 072 A1**

(12) **EUROPÄISCHE PATENTANMELDUNG**

(43) Veröffentlichungstag:
**12.12.2018 Patentblatt 2018/50**

(51) Int Cl.:
*G01R 33/483* (2006.01)   *G01R 33/561* (2006.01)

(21) Anmeldenummer: **17174507.8**

(22) Anmeldetag: **06.06.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Healthcare GmbH**
**91052 Erlangen (DE)**

(72) Erfinder:
• **Carinci, Flavio**
**91052 Erlangen (DE)**
• **Zeller, Mario**
**91054 Erlangen (DE)**

(54) **MRT-SCHICHT-MULTIPLEXING-VERFAHREN**

(57) In einem erfindungsgemäßen Schicht-Multiplexing-Verfahren werden Messungen unter Aufprägen von zusätzlichen Phasen wiederholt durchgeführt, wobei bei jeder Wiederholung die zusätzlich aufgeprägten Phasen derart geändert werden, dass zumindest ein zentraler k-Raumbereich vollständig im Rahmen der wiederholten Aufnahmen abgetastet wird. Aus den in dem zentralen k-Raumbereich vollständig aufgenommenen Messdaten wird ein Kalibrierungsdatensatz bestimmt, der bei einem Rekonstruieren von Bilddaten der simultan angeregten Schichten aus den aufgenommenen Messdaten verwendet wird.

FIG 2

EP 3 413 072 A1

**Beschreibung**

Die Erfindung betrifft ein Verfahren zur Erzeugung von Messdaten von mindestens zwei sich nicht überschneidenden Schichten eines Untersuchungs-objektes mittels Magnetresonanztechnik unter Verwendung einer Messsequenz, die Messpunkte auf einer k-Raumtrajektorie festlegt und mindestens einen Multi-Band-RF-Anregungspuls umfasst, der die mindestens zwei sich nicht überschneidenden Schichten simultan und selektiv anregt.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Um bei MR-Messungen das Signal-zu-Rausch-Verhältnis (SNR, engl. "signal to noise ratio") zu verbessern oder eine Bewegungs- und/oder Flusssensitivität der Messung zu verringern, ist es bei vielen Aufnahmen bereits üblich, Messdaten mehrfach aufzunehmen, um Mittelungen an den Messdaten oder z.B. an den rekonstruierten Bilddaten vornehmen zu können (engl. "averaging").

Der Wunsch nach immer schnelleren MR-Aufnahmen im klinischen Umfeld führt momentan zu einer Renaissance von Verfahren, bei denen mehrere Bilder simultan aufgenommen werden. Allgemein lassen sich diese Verfahren dadurch charakterisieren, dass zumindest während eines Teils der Messung gezielt Transversalmagnetisierung von zumindest zwei Schichten gleichzeitig für den Bildgebungsprozess genutzt wird ("Multi-Schicht-Bildgebung", "Schicht-Multiplexing"). Im Gegensatz dazu wird bei der etablierten "Mehrschicht-Bildgebung" das Signal von zumindest zwei Schichten alternierend, d. h. vollständig unabhängig voneinander mit entsprechender längerer Messzeit aufgenommen.

Bekannte Verfahren hierzu sind beispielsweise die sogenannte Hadamard-Kodierung, Verfahren mit simultaner Echo-Refokussierung, Verfahren mit Breitband-Datenaufnahme oder auch Verfahren, die eine parallele Bildgebung in SchichtRichtung einsetzten. Zu den letztgenannten Verfahren gehören beispielsweise auch die CAIPIRINHA-Technik, wie sie von Breuer et al. in "Controlled Aliasing in Parallel Imaging Results in Higher Acceleration (CAIPIRINHA) for Multi-Slice Imaging", Magnetic Resonance in Medicine 53, 2005, S. 684-691 beschrieben ist, und die blipped CAIPIRINHA-Technik, wie sie von Setsompop et al. in "Blipped-Controlled Aliasing in Parallel Imaging for Simultaneous Multislice Echo Planar Imaging With Reduced g-Factor Penalty", Magnetic Resonance in Medicine 67, 2012, S. 1210-1224, beschrieben wird.

Insbesondere bei den letztgenannten Schichtmultiplexing-Verfahren wird ein sogenannter Multi-Band-RF-Puls verwendet, um zwei oder mehr Schichten gleichzeitig anzuregen oder anderweitig zu manipulieren, z.B. zu refokussieren oder zu sättigen. Ein solcher Multi-Band-RF-Puls ist dabei z.B. ein Multiplex von individuellen RF-Pulsen, die zur Manipulation der einzelnen gleichzeitig zu manipulierenden Schichten verwendet werden würden. Durch das Multiplexing erhält man z.B. einen grundbandmodulierten Multi-Band-RF-Puls aus einer Addition der Pulsformen der individuellen RF-Pulse. Die Ortskodierung der aufgenommenen Signale wird dabei im Wesentlichen durch eine gängige Gradientenschaltung in zwei Richtungen (zweidimensionale Gradientenkodierung) erreicht.

Die entstehenden Signale werden aus allen angeregten Schichten kollabiert in einem Datensatz mittels mehreren Empfangsantennen aufgenommen und dann mit Hilfe von parallelen Akquisitionstechniken nach den einzelnen Schichten getrennt.

Zu den genannten parallelen Akquisitionstechniken, mit deren Hilfe sich bereits generell zur Aufnahme der gewünschten Daten benötigte Akquisitionszeiten durch eine gemäß Nyquist nicht vollständige, d.h. eine Unterabtastung des k-Raums verkürzen lassen, zählen z.B. GRAPPA ("GeneRalized Autocalibrating Partially Parallel Acquisition") und SENSE ("SEN-Sitivity Encoding"). Die im Rahmen der Unterabtastung nichtgemessenen Messpunkte im k-Raum sind bei parallelen Akquisitionstechniken in der Regel gleichmäßig über den gemäß Nyquist zu messenden k-Raum verteilt, sodass z.B. jede zweite k-Raumzeile gemessen wird. Darüber hinaus werden die "fehlenden" k-Raumdaten bei parallelen Akquisitionstechniken mit Hilfe von Spulensensitivitätsdaten rekonstruiert. Diese Spulensensitivitätsdaten der bei der Aufnahme der Messdaten verwendeten Empfangsspulen werden aus Referenzmessdaten ermittelt, die zumindest einen Bereich des zu messenden k-Raums, meist den zentralen Bereich, vollständig gemäß der Nyquist-Bedingung abtasten.

Bei Schichtmultiplexing-Verfahren werden parallele Akquisitionstechniken verwendet, um die gleichzeitig für verschiedene Schichten aufgenommenen Messdaten wieder zu trennen. Dabei müssen Referenzmessdaten für alle betroffenen Schichten aufgenommen werden. Dies geschieht in der Regel im Rahmen einer zusätzlich durchzuführenden Referenzmessung, die Referenzmessdaten einzeln für jede gewünschte Schicht misst.

Um die resultierenden Signale der verschiedenen Schichten trennen zu können, wird beispielsweise den individuellen RF-Pulsen vor dem Multiplexing, z.B. durch Addieren einer Phase, die linear (z.B. mit der k-Raumkoordinate in die Phasenkodierrichtung ($k_y$)) steigt, je eine unterschiedliche Phase aufgeprägt. Damit kann jeder Schicht ein unterschiedlicher Phasenanstieg aufgeprägt werden, wodurch die Schichten im Bildraum gegeneinander verschoben werden. Diese Verschiebung wird durch den sogenannten Bildbereich-Verschiebungsfaktor ("FOV (field of view) shift factor") kontrolliert. Wie ein optimaler FOV shift factor bestimmt werden kann, wird beispielsweise in der nachveröffentlichten DE102016218955 beschrieben.

In den genannten Artikel von Breuer et al. und Setsompop et al. beschriebenen CAIPIRINHA-Verfahren werden durch Schalten von zusätzlichen Gradientenblips oder durch zusätzliches Modulieren der Phasen der RF-Pulse der Multi-Band-RF-Pulse zwischen den gleichzeitig angeregten Schichten wechselnde weitere Phasenverschiebungen aufgeprägt, die Verschiebungen im Bildraum erzeugen. Diese zusätzlichen Verschiebungen im Bildraum verbessern die Qualität der Trennung der Signale der Schichten, insbesondere, wenn die Spulensensitivitäten derartig geringe Unterschiede in den Sensitivitätsprofilen der einzelnen verwendeten Spulen aufweisen, dass diese nicht für eine zuverlässige Trennung der Schichten ausreichen. Somit werden Artefakte in den letztendlich aus den gemessenen Messdaten rekonstruierten Bilddaten verringert.

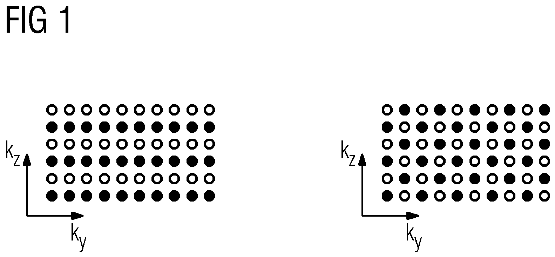

In Figur 1 sind beispielhaft verschiedenen Abtastschemata des k-Raums für GRAPPA-artige parallele Bildgebungstechniken, jeweils mit Beschleunigungsfaktor 2 und einem dreidimensionalen (3D) kartesischen Abtastschema, das jeweils k-Raumlinien in der $k_y$-$k_x$-Ebene abtastet, gegenübergestellt. Die $k_x$-Richtung, in der die dargestellten k-Raumlin ien im Beispiel verlaufen, liegt hierbei senkrecht zur Blattebene und das Abtastschema ist in $k_x$-Richtung immer gleich. Die gefüllten Kreise repräsentieren gemessene k-Raumpunkte, die leeren Kreise ausgelassene k-Raumpunkte. Das linke Abtastschema zeigt eine herkömmliche GRAPPA-Abtastung, in der jede zweite k-Raumlinie in einer Raumrichtung (hier: $k_z$-Richtung) ausgelassen wird, und somit nur die Hälfte der k-Raumpunkte gemessen werden.

Die Wirkung der zusätzlichen Phasenverschiebungen auf das Abtastschema einer zweidimensionalen (2D) Schicht-Multiplexing-Messung kann so beschrieben werden (siehe Figur 1 rechts): Durch die zusätzlichen Phasen, die in Schicht-Multiplexing CAIPIRNHA-Verfahren aufgeprägt werden, werden die mit der zusätzlichen Phase beaufschlagten Messpunkte durch eine Verschiebung im k-Raum in $k_z$-Richtung verschoben. Wie groß diese Verschiebung in $k_z$-Richtung ausfällt, hängt von der aufgeprägten Phase ab. Dies ist beispielsweise auch in dem Artikel von Zahneisen et al.: "Three-Dimensional Fourier Encoding of Simultaneously Excited Slices: Generalized Acquisition and Reconstruction Framework", Magn. Reson. Med. 71, S. 2071-2081 (2014), beschrieben.

Die Referenzdaten, aus denen die Sensitivitätsdaten gewonnen werden, müssen bisher für jede SMS-Messung zusätzlich gemessen werden. Die zusätzliche Aufnahme der Referenzmessdaten erhöht die insgesamt benötigte Aufnahmezeit und die SAR-Belastung (SAR: "Spezifische AbsorptionsRate") bei Verwendung eines Schicht-Multiplexing-Verfahrens und reduziert somit die eigentlich bei diesen Verfahren angestrebten Vorteile einer gegenüber Einzelschicht-Verfahren reduzierten Messzeit und SAR-Belastung.

Weiterhin können Abweichungen in den bei der Aufnahme der Referenzmessdaten verwendeten Messparametern von den bei der Multi-Band-Aufnahme verwendeten Messparametern, insbesondere Messparameter bezüglich der Eigenschaften der RF-Anregungspulse und/oder bezüglich des Auslesevorgangs, wie z.B. die Auslesebandbreite, die Qualität der Trennung der Schichten beeinflussen und zu ungewünschten Artefakten führen. Unter diesem Gesichtspunkt sind in der nachveröffentlichten US-Patentanmeldung 15/262,233 bereits verschiedene Verfahren beschrieben, auf welche Weise derartige Referenzmessdaten neben den Multi-Band-Messdaten gewonnen werden können, wobei die Referenzdaten immer noch zusätzlich zu dem Messdaten aufgenommen werden müssen.

Der Erfindung liegt die Aufgabe zugrunde, die durch die zusätzliche Aufnahme von Referenzmessdaten neben der Aufnahme der Multi-Band-Messdaten verursachten Nachteile bei Schicht-Multiplexing-Verfahren zu vermeiden ohne die Qualität der gewonnenen nach Einzelschichten getrennten Messdaten zu verringern.

Die Aufgabe wird gelöst durch ein Verfahren zur Erzeugung von Messdaten von mindestens zwei sich nicht überschneidenden Schichten eines Untersuchungs-objektes mittels Magnetresonanztechnik gemäß Anspruch 1, eine Magnetresonanzanlage gemäß Anspruch 12, ein Computerprogrammprodukt gemäß Anspruch 13 sowie einen elektronisch lesbaren Datenträger gemäß Anspruch 14.

Ein erfindungsgemäßes Verfahren zur Erzeugung von Messdaten von mindestens zwei sich nicht überschneidenden Schichten eines Untersuchungs-objektes mittels Magnetresonanztechnik unter Verwendung einer Messsequenz, die Messpunkte auf einer k-Raumtrajektorie festlegt und mindestens einen Multi-Band-RF-Anregungspuls umfasst, der die mindestens zwei sich nicht überschneidenden Schichten simultan und selektiv anregt, umfasst die Schritte:

- Bestimmen von im Verlauf einer Ausführung der Messsequenz jeder der simultan angeregten Schichten zusätzlich aufzuprägenden Phasen, sodass entsprechend der zusätzlich aufgeprägten Phasen mindestens ein erster der gemessenen k-Raumpunkte in einer k-Raumrichtung von der ursprünglichen k-Raumtrajektorie der Messsequenz weg verschoben ist,

- Aufnehmen von Messdaten unter Verwendung von mindestens zwei Empfangsspulen auf Basis der Messsequenz unter Aufprägen der bestimmten zusätzlichen Phasen,

- Wiederholen der Aufnahme von Messdaten mit den mindestens zwei Empfangsspulen auf Basis der Messsequenz, wobei die zusätzlich aufzuprägenden Phasen gegenüber der vorhergehenden Aufnahme von Messdaten derart verändert sind, dass mindestens ein zweiter, in den bisher durchgeführten Aufnahmen noch nicht von der ursprünglichen k-Raumtrajektorie weg verschobener, der durch die Messsequenz gemessenen k-Raumpunkte in der k-Raumrichtung von der ursprünglichen k-Raumtrajektorie weg verschoben ist, wobei die Aufnahme der Messdaten unter Anpassung der zusätzlichen Phasen mindestens so oft und derart wiederholt wird, dass zumindest ein zentraler k-Raumbereich vollständig im Rahmen der wiederholten Aufnahmen abgetastet wird,

- Bestimmen eines Kalibrierungsdatensatzes aus den in dem zentralen k-Raumbereich aufgenommenen Messdaten,

- Rekonstruieren von Bilddaten der simultan angeregten Schichten aus den aufgenommenen Messdaten unter Verwendung des Kalibrierungsdatensatzes.

In einem erfindungsgemäßen Schicht-Multiplexing-Verfahren werden somit Messungen unter Aufprägen von zusätzlichen Phasen wiederholt durchgeführt, wobei bei jeder Wiederholung die zusätzlich aufgeprägten Phasen derart geändert werden, dass zumindest ein zentraler k-Raumbereich vollständig im Rahmen der wiederholten Aufnahmen abgetastet wird. Aus den in dem zentralen k-Raumbereich vollständig aufgenommenen Messdaten wird ein Kalibrierungsdatensatz bestimmt, der bei einem Rekonstruieren von Bilddaten der simultan angeregten Schichten aus den aufgenommenen Messdaten verwendet wird.

Mit dem erfindungsgemäßen Verfahren kann somit auf bisher nötige zusätzliche Kalibrierungsmessungen zur Bestimmung von Kalibrierungsdaten verzichtet werden.

Insbesondere, wenn Messungen geplant wiederholt durchgeführt werden sollen, z.B. um durch Averaging die Qualität der gewonnenen Mess- und/oder Bilddaten zu verbessern, wird so die Messzeit nicht durch Kalibrierungsmessungen verlängert.

Mit dem erfindungsgemäßen Verfahren werden Kalibrierungsdaten aus denselben Messdaten bestimmt, aus denen auch die gewünschten Bilddaten rekonstruiert werden. Damit sind die Messparameter der Messdaten, aus denen die Kalibrierungsdaten bestimmt werden, und die Messparameter der Messdaten, aus denen Bilddaten rekonstruiert werden, gleich, wodurch die Kalibrierungsdaten inhärent auf die Messdaten, die unter Verwendung der Kalibrierungsdaten ergänzt werden sollen, abgestimmt sind. Somit werden Artefakte effektiv vermieden.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung mit einer Multi-Band-RF-Pulseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Fig. 1 eine schematische Gegenüberstellung verschiedener Abtastschemata des k-Raums für parallele Akquisitionstechniken,

Fig. 2 ein schematisches Ablaufdiagramm eines erfindungsgemäßen Verfahrens,

Fig. 3 eine schematische Darstellung einer erfindungsgemäßen k-Raumabtastung,

Fig. 4 eine weitere schematische Darstellung einer erfindungsgemäßen k-Raumabtastung,

Fig. 5 eine schematische Darstellung einer erfindungsgemäßen Magnetresonanzanlage.

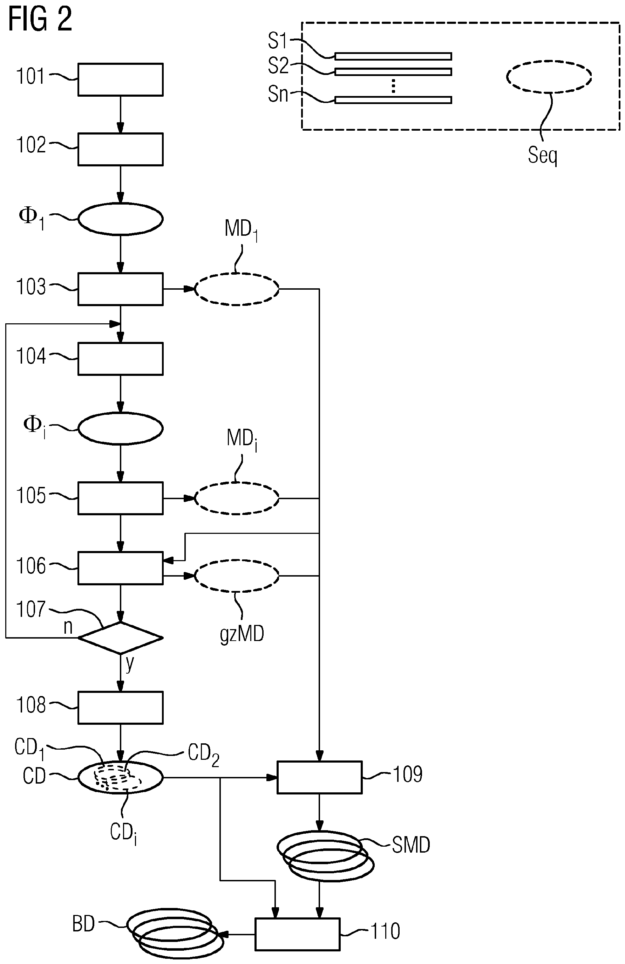

Figur 2 ist ein schematisches Ablaufdiagramm eines erfindungsgemäßen Verfahrens zur Erzeugung von Messdaten von mindestens zwei sich nicht überschneidenden Schichten Sn (n ≥ 2) eines Untersuchungsobjektes mittels Magnetresonanztechnik.

Dabei werden die Messdaten auf Basis einer Messsequenz Seq aufgenommen, die Messpunkte auf einer k-Raumtrajektorie festlegt und mindestens einen Multi-Band-RF-Anregungspuls umfasst, der die mindestens zwei sich nicht überschneidenden Schichten Sn simultan und selektiv anregt.

Die Messsequenz legt die grundsätzlich einzustrahlenden RF-Pulse, zu schaltenden Gradienten und Auslesevorgänge und ihre zeitliche Abfolge fest. Diese Festlegung bestimmt somit die k-Raumtrajektorie, entlang welcher bei der Aufnahme der Messpunkte der k-Raum abgetastet wird.

Als Messsequenz kann insbesondere eine für die Aufnahme von Messdaten in Schichten übliche zweidimensionale Messsequenz verwendet werden, bei der die durch die Messsequenz festgelegte k-Raumtrajektorie in einer Ebene im k-Raum liegt. Die k-Raumrichtung, in die Messpunkte durch Aufprägen der zusätzlichen Phase verschoben werden, kann dann senkrecht zu dieser Ebene der k-Raumtrajektorie stehen, um die mehreren Schichten abdecken zu können. Eine derartige Wahl der Messsequenz erleichtert eine Implementierung des erfindungsgemäßen Verfahrens auf Magnetresonanzanlagen, da solche Messsequenzen in der Regel bereits verfügbar sind und somit auf vorhandene Protokolle, insbesondere von CAIPIRINHA-Verfahren, zurückgegriffen werden kann.

Es werden zusätzlich aufzuprägende Phasen $\phi_1$ bestimmt, die im Verlauf einer (ersten) Ausführung der Messsequenz Seq (i=1) den simultan angeregten Schichten Sn jeweils aufgeprägt werden sollen (Block 102), wobei der Index i die Wiederholungen der Aufnahme von Messdaten unter Verwendung der Messsequenz zählt. Durch das Aufprägen der zusätzlichen Phasen $\phi_1$ wird, in dem im Rahmen einer Aufnahme von Messdaten unter Verwendung der Messsequenz Seq und unter Aufprägen der bestimmten zusätzlichen Phasen $\phi_1$ abgetasteten k-Raum, entsprechend der zusätzlich aufgeprägten Phasen $\phi_1$ mindestens ein erster der gemessenen k-Raumpunkte in einer k-Raumrichtung von der ursprünglichen k-Raumtrajektorie der Messsequenz Seq weg verschoben. Insbesondere kann für jede der simultan angeregten Schichten Sn eine eigene zusätzliche Phase bestimmt werden, sodass keinen zwei der simultan angeregten Schichten Sn dieselbe zusätzliche Phase $\phi_1$ aufgeprägt wird.

Die k-Raumrichtung, in welche der mindestens eine k-Raumpunkt der k-Raumtrajektorie verschoben wird, kann insbesondere der Schichtrichtung ($k_z$) im k-Raum entsprechen.

Die zusätzlichen Phasen $\phi_1$ können beispielsweise durch zusätzliche zu schaltende Gradienten und/oder durch Manipulation der Phasen der Einzel-RF-Pulse der verwendeten Multi-Band-RF-Anregungspulse aufgeprägt werden. Insbesondere können die zusätzlichen Phasen $\phi_1$ gemäß eines CAIPIRINHA-Verfahrens aufgeprägt werden.

Hierzu kann eine gewünschte Verschiebung im Bildraum bestimmt werden (Block 101) und die bestimmten zusätzlich aufzuprägenden Phasen $\phi_1$ können derart

bestimmt werden, dass sie die gewünschte Verschiebung im Bildraum in die aufgenommenen Messdaten $MD_1$ einbringen.

Insbesondere kann hierbei für jede der Schichten Sn eine gewünschte Verschiebung im Bildraum bestimmt werden, um die jeweils eine Schicht der simultan angeregten Schichten Sn, nach einer Transformation der alle Schichten Sn enthaltenden Messdaten $MD_1$ in den Bildraum, im Bildraum verschoben sein sollen, sodass die Schichten Sn im Bildraum jeweils gegeneinander verschoben sind. Die somit für jede der simultan angeregten Schichten Sn bestimmten zusätzlich aufzuprägenden Phasen $\phi_1$ können hierbei derart bestimmt werden, dass sie, in den alle simultan angeregten Schichten Sn enthaltenden aufgenommenen Messdaten $MD_1$, die gewünschte jeweilige Verschiebung im Bildraum für jede der simultan angeregten Schichten Sn einbringen.

Die gewünschte Verschiebung im Bildraum kann z.B. auf Basis der Anzahl N der simultan angeregten Schichten Sn bestimmt werden, beispielsweise indem jede der simultan angeregten Schichten Sn um ein Vielfaches den N-ten Teils des Bildbereichs FOV (engl. "field of view") verschoben sein soll, beispielsweise um

$$(n-1)\frac{FOV}{N}.$$

Wie es z.B. in dem bereits genannten Artikel von Zahneisen et al. beschrieben ist, führt eine derartige Wahl der gewünschten Verschiebung im Bildraum zu einer Verschiebung der gemessenen k-Raumpunkte im k-Raum (in die $k_z$-Richtung) um einen Betrag, der einer gemäß Nyquist vollständigen Abtastung in dieser k-Raumrichtung entspricht. Damit kann eine 2D Schicht-Multiplexing-Messung analog zu einer 3D CAIPIRIHNA-Messung betrachtet werden.

Die gewünschte Verschiebung im Bildraum kann aber auch gemäß eines Verfahrens der bereits genannten DE102016218955 erfolgen.

Bei dem in Figur 2 beschriebenen Verfahren werden Messdaten $MD_1$ im Rahmen einer ersten Aufnahme unter Verwendung von mindestens zwei Empfangsspulen auf Basis der Messsequenz Seq unter Aufprägen der bestimmten zusätzlichen Phasen $\phi_1$ aufgenommen (Block 103).

Die Aufnahme von Messdaten mit den mindestens zwei Empfangsspulen auf Basis der Messsequenz Seq wird wiederholt (Block 105) wodurch weitere Messdaten $MD_i$ aufgenommen werden. Bei einer solchen wiederholten Aufnahme von Messdaten (i $\geq$ 2) sind jeweils zusätzlich aufzuprägende Phasen $\phi_i$ gegenüber der vorhergehenden Aufnahme von Messdaten mit Zählindex j < i derart verändert, dass mindestens ein zweiter, in den bisher durchgeführten Aufnahmen noch nicht von der ursprünglichen k-Raumtrajektorie weg verschobener, der durch die Messsequenz Seq gemessenen k-Raumpunkte in der k-Raumrichtung von der ursprünglichen k-Raumtrajektorie weg verschoben ist. Eine Bestimmung von für eine Wiederholung anzuwendenden zusätzlich

aufzuprägenden Phasen $\phi_i$ (Block 104) kann insbesondere unter Berücksichtigung der in vorhergehenden Aufnahmen bereits mindestens einmal verschobenen k-Raumpunkten erfolgen. Dabei kann die Bestimmung der für eine Wiederholung anzuwendenden zusätzlich aufzuprägenden Phasen $\phi_i$ zusätzlich oder alternativ berücksichtigen, welche k-Raumpunkte für die gewünschte vollständige Abtastung zumindest in dem zentralen k-Raumbereich noch nicht aufgenommen sind. Dadurch kann die Anzahl an durchzuführenden Wiederholungen möglichst klein gehalten werden.

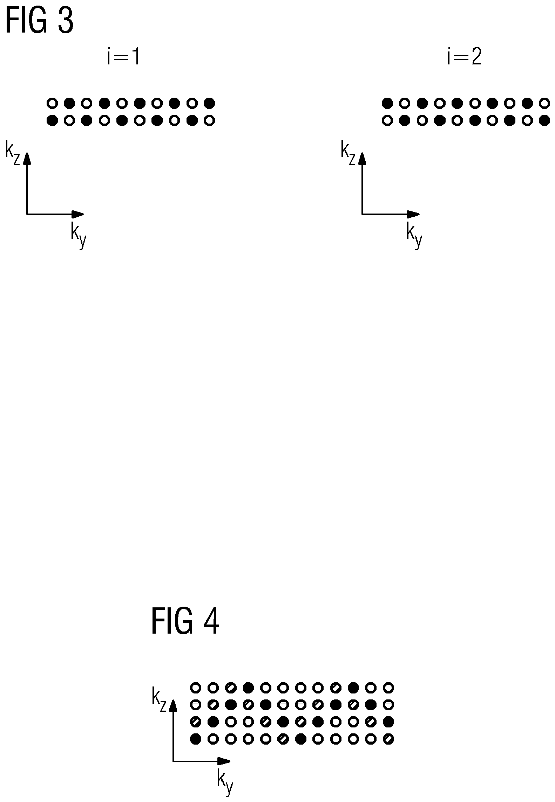

Ein Beispiel für eine Bestimmung einer für eine Wiederholung anzuwendenden zusätzlich aufzuprägenden Phasen $\phi_i$ soll anhand von Figur 3 veranschaulicht werden, in der beispielhaft das Prinzip einer k-Raumabtastung mit einem Bildbereich-Verschiebungsfaktor von $\frac{FOV}{2}$ für eine erste Aufnahme (i=1) und eine Wiederholung der Aufnahme (i=2) dargestellt ist. Dabei liegt, wie bereits in Figur 1, die $k_x$-Richtung senkrecht zur Blattebene. Somit ist in Figur 3 ein kartesisches Abtastschema dargestellt. Das Verfahren kann analog auch bei nichtkartesischen Abtastschemata, z.B. radialen oder spiralen Abtastschemata, angewandt werden.

In Figur 3 sind analog zu Figur 1 aufgenommene k-Raumpunkte als schwarz gefüllte Kreise dargestellt wohingegen nicht aufgenommene k-Raumpunkte als weiß gefüllte Kreise dargestellt sind. In der links gezeigten ersten Aufnahme ist in ky-Richtung jeder zweite k-Raumpunkt durch zusätzlich aufgeprägte Phasen $\phi_1$ in $k_z$-Richtung verschoben. Dies kann z.B. durch Anwenden einer CAIPIRINHA-Technik erreicht werden. In der rechts gezeigten Wiederholung sind die zusätzlichen Phasen $\phi_i$ derart geändert, dass wiederum in $k_y$-Richtung jeder zweite k-Raumpunkt durch zusätzlich aufgeprägte Phasen $\phi_2$ in $k_z$-Richtung verschoben ist, jedoch sind in der Wiederholung gerade diejenigen k-Raumpunkte in $k_z$-Richtung verschoben, die in der ersten Aufnahme nicht verschoben waren. In dem gezeigten Beispiel kann somit durch einfaches Tauschen der mit zusätzlichen Phasen $\phi_i$ belegten k-Raumpunkte in Wiederholungen der Aufnahme die gewünschte vollständige k-Raumabtastung sogar für den gesamten k-Raum erreicht werden.

Für andere Beschleunigungsfaktoren und/oder Bildbereich-Verschiebungsfaktoren kann ein derartiges Tauschen der mit zusätzlichen Phasen beaufschlagten k-Raumpunkte analog erfolgen, wobei die Anzahl der für eine, zumindest bereichsweise, vollständige Abtastung nötigen Wiederholungen von den verwendeten Beschleunigungsfaktoren und Bildbereich-Verschiebungsfaktoren abhängt.

Beispielsweise könnte bei einem Bildbereich-Verschiebungsfaktor von $\frac{FOV}{3}$ bei einem ansonsten analogen Abtastschema in drei Wiederholungen, bei denen die mit zusätzlich aufgeprägten Phasen $\phi_i$ belegten k-Raumpunkte jeweils permutiert werden, der gewünschte k-Raumbereich vollständig abgetastet werden.

Ein weiteres Beispiel für ein Tauschen der mit den zusätzlichen Phasen beaufschlagten k-Raumpunkte ist in Figur 4 dargestellt. Hierbei ist ein Abtastschema für einen Bildbereich-Verschiebungsfaktor von $\frac{FOV}{4}$ dargestellt, bei dem die zusätzlich aufzuprägenden Phasen in insgesamt vier Wiederholungen der Aufnahme der Messdaten derart verteilt sind, dass der gewünschte k-Raumbereich durch die vier Aufnahmen vollständig abgetastet ist. In Figur 4 sind die in einer Aufnahme gemessenen k-Raumpunkte jeweils als jeweils gleich gefüllte Kreise dargestellt. Beispielsweise werden in einer ersten Aufnahme die als schwarz gefüllte Kreise dargestellten k-Raumpunkte, in einer zweiten Aufnahme die als schräg von links unten nach rechts oben gestreift gefüllte Kreise dargestellten k-Raumpunkte, in einer dritten Aufnahme die als horizontal quer gestreift gefüllte Kreise dargestellten k-Raumpunkte und in einer vierten Aufnahme die als weiß gefüllte Kreise dargestellten k-Raumpunkte gemessen.

Bei jeder Wiederholung der Aufnahme von Messdaten wird durch die Verwendung derselben Messsequenz jeweils dieselbe Anzahl an k-Raumpunkten abgetastet.

Eine solche Aufnahme von Messdaten $MD_i$ mit jeweils angepassten zusätzlichen aufzuprägenden Phasen $\phi_i$ wird so oft und mit jeweils derart angepassten zusätzlich aufzuprägenden Phasen $\phi_i$ wiederholt, dass zumindest ein zentraler k-Raumbereich gemäß Nyquist vollständig im Rahmen der wiederholten Aufnahmen abgetastet wird (Abfrage 107).

Wird die Messsequenz derart gewählt, dass die durch die Messsequenz festgelegte k-Raumtrajektorie eine gemäß Nyquist vollständige Abtastung des k-Raums ermöglicht, sind weniger Wiederholungen nötig, um den zentralen k-Raumbereich vollständig abzutasten.

Dazu kann ein Gesamtmessdatensatz gzMD aus den bisher aufgenommenen Messdaten $MD_i$ gebildet werden, der mindestens alle bisher gemessenen Messdaten in einem vorgegebenen zentralen k-Raumbereich, oder auch alle bisher gemessenen Messdaten $MD_i$ umfasst (Block 106).

Ergibt die Abfrage 107 dass der zentrale k-Raumbereich noch nicht vollständig durch die bisher durchgeführten Wiederholungen abgetastet wurde ("n"), wird eine erneute Wiederholung mit neuen zusätzlich aufzuprägenden Phasen $\phi_i$ gestartet (Block 104).

Ergibt die Abfrage 107 dass der zentrale k-Raumbereich bereits vollständig durch die bisher durchgeführten Wiederholungen abgetastet wurde ("y"), wird ein Kalibrierungsdatensatz CD aus den vollständigen in dem zentralen k-Raumbereich aufgenommenen Messdaten bestimmt (Block 108).

Insbesondere kann für jeden oder mindestens zwei der im Rahmen einer Aufnahme aufgenommenen Messdaten $MD_i$, in denen jeweils verschiedene k-Raumpunkte der eigentlichen k-Raumtrajektorie in der k-Raumrichtung verschoben sind, ein Aufnahme-Kalibrierungsdatensatz $CD_i$ bestimmt werden, mittels welchem die jeweils verschobenen, und damit in der ursprünglichen k-Raumtrajektorie fehlenden k-Raumpunkte rekonstruiert werden können. Der Kalibrierungsdatensatz CD kann somit mehrere Aufnahme-Kalibrierungsdatensätze $CD_i$ enthalten.

Aus den aufgenommenen Messdaten $MD_i$ (i= 1, 2, ...) werden unter Verwendung des Kalibrierungsdatensatzes CD Bilddaten BD der simultan angeregten Schichten Sn rekonstruiert (Block 110). Dabei wird für jede der simultan angeregten Schichten Sn mindestens ein Bilddatensatz BD rekonstruiert.

Die Rekonstruktion der Bilddaten kann ein Trennen der aufgenommenen Messdaten in mindestens einen Schicht-Messdatensatz SMD pro simultan angeregter Schicht Sn umfassen (Block 109).

Ein solches Trennen der aufgenommenen Messdaten kann auf Basis einer parallelen Akquisitionstechnik, beispielsweise eines Schicht-GRAPPA-Verfahrens (Slice-GRAPPA), wie es in dem bereits genannten Artikel von Breuer et al. beschrieben ist, unter Verwendung des Kalibrierungsdatensatzes CD durchgeführt werden. Eine solche Trennung kann für die jeweils im Rahmen einer Aufnahme aufgenommenen Messdaten $MD_i$ jeweils separat z.B. mit einem zugehörigen Aufnahme-Kalibrierungsdatensatz $CD_i$ erfolgen, womit für jede Aufnahme jeweils zugehörige Schicht-Messdatensätze SMD pro simultan angeregter Schicht Sn erzeugt werden können. Damit können pro simultan angeregter Schicht mehrere Schicht-Messdatensätze SMD erzeugt werden. Durch die bei jeder Wiederholung angepassten und damit geänderten zusätzlich aufzuprägenden Phasen $\phi_i$ wird eine die Variation der in den Aufnahmen verwendeten zusätzlichen Phasen erhöht, was bereits eine Verbesserung der Robustheit der Trennung der Schichten mittels paralleler Akquisitionstechniken mit sich bringt.

Wenn der gespeicherte Gesamtmessdatensatz gzMD in der k-Raumrichtung, in der k-Raumpunkte durch die zusätzlichen Phasen $\phi_i$ verschoben werden, z.B. der Schichtrichtung $k_z$, vollständig gemäß Nyquist ist, kann aus dem Gesamtmessdatensatz durch Anwenden einer Fouriertransformation in der der Verschiebung entsprechenden Richtung ein zugehöriger Schicht-Messdatensatz SMD pro angeregter Schicht extrahiert und gespeichert werden.

Hierbei sind zur Trennung der Messdaten in Schicht-Messdaten keine Kalibrierungsdaten erforderlich. Die Kalibrierungsdaten können für eine Ergänzung fehlender Messdaten in der Ebene der k-Raumtrajektorie der Messsequenz verwendet werden, z.B. für eine Ergänzung von in Phasenkodierrichtung unterabgetasteten Messdaten.

Das Rekonstruieren der Bilddaten kann ein Trennen der aufgenommenen Messdaten in mindestens zwei Schicht-Messdatensätze SMD pro simultan angeregter Schicht Sn umfassen. Beispielsweise kann aus mehreren der pro Aufnahme aufgenommenen Messdaten $MD_i$ jeweils ein Schicht-Messdatensatz SMD für jede der simultan angeregten Schichten Sn herausgetrennt werden.

Die Schicht-Messdatensätze SMD können selbst gemäß Nyquist unvollständig sein. Dann können die gemäß Nyquist fehlenden k-Raumpunkte unter Verwendung einer parallelen Akquisitionstechnik und des Kalibrierungsdatensatzes CD rekonstruiert und in den Schicht-Messdatensätzen ergänzt werden. Somit kann die Rekonstruktion der Bilddaten eine derartige Ergänzung unvollständiger Schicht-Messdatensätze SMD umfassen.

Sind mehrere Schicht-Messdatensätze SMD pro simultan angeregter Schicht Sn bestimmt worden, kann das Rekonstruieren der Bilddaten BD eine Mittelung von mindestens zwei der Schicht-Messdatensätze SMD jeweils mindestens einer der simultan angeregten Schichten Sn zu einem gemittelten Schicht-Messdatensatz der jeweiligen Schicht umfassen.

Zusätzlich oder alternativ kann das Rekonstruieren der Bilddaten BD eine Mittelung von aus mehreren Schicht-Messdatensätzen SMD jeweils einer Schicht rekonstruierten Bilddaten der jeweiligen Schicht umfassen.

Derartige Mittelungen erhöhen die Qualität der letztendlich gewonnenen Bilddaten, indem sie die Sensitivität gegenüber Bewegungen des Untersuchungsobjekts, z.B. auch Atembewegungen oder Pulsbewegungen, reduzieren und das SNR verbessern.

Das Rekonstruieren der Bilddaten kann weiterhin Maßnahmen zum Ausgleich von möglicherweise durch die zusätzlich aufgeprägten Phasen verursachten ungewünschten Phasenversätzen umfassen.

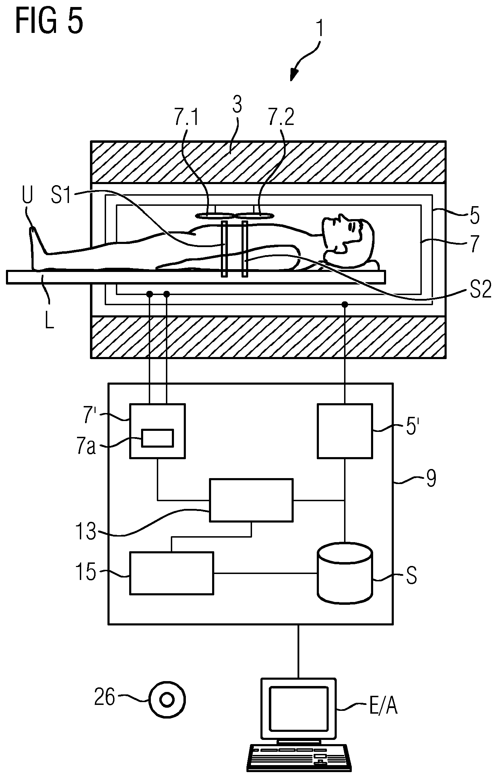

Figur 5 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 5 sind diese Teileinheiten der Magnetresonanzanlage 1 nur grob schematisch dargestellt. Insbesondere besteht die Hochfrequenzeinheit 7 aus mehreren Untereinheiten, insbesondere aus mindestens zwei Spulen wie den schematisch gezeigten Spulen 7.1 und 7.2, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schichten S1 und S2 stellen exemplarisch zwei unterschiedlichen Schichten S1 und S2 des Untersuchungsobjekts dar, die bei einer Aufnahme von MR-Signalen gleichzeitig gemessen werden können.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (insbesondere in verschiedene Schichten S1 und S2) des Untersuchungsobjekt U zuständig. Dabei sollte die Mittenfrequenz des auch als B1-Feld bezeichneten Hochfrequenz-Wechselfeldes nahe der Resonanzfrequenz der zu manipulierenden Spins liegen. Zur Erzeugung des B1-Feldes werden in der Hochfrequenzeinheit 7 mittels der Hochfrequenz-sende/empfangs-Steuerung 7' gesteuerte Ströme an den HF-Spulen angelegt.

Weiterhin umfasst die Steuereinrichtung 9 eine Phasenbestimmungseinheit 15 insbesondere zum Bestimmen von erfindungsgemäß zusätzlich aufzuprägenden Phasen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

**Patentansprüche**

1. Verfahren zur Erzeugung von Messdaten von mindestens zwei sich nicht überschneidenden Schichten eines Untersuchungsobjektes mittels Magnetresonanztechnik unter Verwendung einer Messsequenz, die Messpunkte auf einer k-Raumtrajektorie festlegt und mindestens einen Multi-Band-RF-Anregungspuls umfasst, der die mindestens zwei sich nicht überschneidenden Schichten simultan und selektiv anregt, umfassend die Schritte:

   - Bestimmen von im Verlauf einer Ausführung der Messsequenz jeder der simultan angeregten Schichten zusätzlich aufzuprägenden Phasen, sodass entsprechend der zusätzlich aufgeprägten Phasen mindestens ein erster der gemessenen k-Raumpunkte in einer k-Raumrichtung von der ursprünglichen k-Raumtrajektorie der Messsequenz weg verschoben ist,
   - Aufnehmen von Messdaten unter Verwendung von mindestens zwei Empfangsspulen auf Basis der Messsequenz unter Aufprägen der bestimmten zusätzlichen Phasen,
   - Wiederholen der Aufnahme von Messdaten mit den mindestens zwei Empfangsspulen auf Basis der Messsequenz, wobei die zusätzlich aufzuprägenden Phasen gegenüber der vorhergehenden Aufnahme von Messdaten derart verändert sind, dass mindestens ein zweiter, in den bisher durchgeführten Aufnahmen noch nicht von der ursprünglichen k-Raumtrajektorie weg verschobener, der durch die Messsequenz gemessenen k-Raumpunkte in der k-Raumrichtung von der ursprünglichen k-Raumtrajektorie weg verschoben ist, wobei die Aufnahme der Messdaten unter Anpassung der zusätzlichen Phasen mindestens so oft und derart wiederholt wird, dass zumindest ein zentraler k-Raumbereich vollständig im Rahmen der wiederholten Aufnahmen abgetastet wird,
   - Bestimmen eines Kalibrierungsdatensatzes aus den in dem zentralen k-Raumbereich aufgenommenen Messdaten,
   - Rekonstruieren von Bilddaten der simultan angeregten Schichten aus den aufgenommenen Messdaten unter Verwendung des mindestens einen Kalibrierungsdatensatzes.

2. Verfahren nach Anspruch 1, wobei als zusätzlich aufzuprägende Phasen für jede der simultan angeregten Schichten jeweils eine andere zusätzlich aufzuprägende Phase bestimmt wird.

3. Verfahren nach einem der vorhergehenden Ansprüche, wobei die zusätzlichen Phasen durch zusätzliche zu schaltende Gradienten und/oder durch Manipulation der Phasen der Einzel-RF-Pulse der Multi-Band-RF-Anregungspulse aufgeprägt werden.

4. Verfahren nach einem der vorhergehenden Ansprüche, wobei die zusätzlichen Phasen gemäß eines CAIPIRINHA-Verfahrens aufgeprägt werden.

5. Verfahren nach einem der vorhergehenden Ansprüche, wobei die durch die Messsequenz festgelegte k-Raumtrajektorie in einer Ebene im k-Raum liegt und die k-Raumrichtung, in die Messpunkte durch Aufprägen einer zusätzlichen Phase verschoben werden, senkrecht zu der Ebene der k-Raumtrajektorie steht.

6. Verfahren nach einem der vorhergehenden Ansprüche, wobei eine gewünschte Verschiebung im Bildraum bestimmt wird, und die zusätzlich aufzuprägenden Phasen in den aufgenommenen Messdaten die gewünschte Verschiebung im Bildraum einbringt.

7. Verfahren nach Anspruch 6, wobei die gewünschte Verschiebung im Bildraum auf Basis der Anzahl der simultan angeregten Schichten bestimmt wird.

8. Verfahren nach einem der vorhergehenden Ansprüche, wobei das Rekonstruieren der Bilddaten ein Trennen der aufgenommenen Messdaten in mindestens einen Schicht-Messdatensatz pro simultan angeregter Schicht umfasst.

9. Verfahren nach Anspruch 8, wobei das Trennen der aufgenommenen Messdaten auf Basis einer parallelen Akquisitionstechnik durchgeführt wird.

10. Verfahren nach Anspruch 8, wobei der gespeicherte Messdatensatz in der k-Raumrichtung, in der k-Raumpunkte durch die zusätzlichen Phasen ($\phi_i$) verschoben werden, vollständig gemäß Nyquist ist, und aus dem Messdatensatz durch Anwenden einer Fouriertransformation in der der Verschiebung entsprechenden Richtung pro angeregter Schicht ein zugehöriger Schicht-Messdatensatz extrahiert und gespeichert wird.

11. Verfahren nach einem der Ansprüche 8 bis 10, wobei das Rekonstruieren der Bilddaten ein Trennen der aufgenommenen Messdaten in mindestens zwei Schicht-Messdatensätze pro simultan angeregter Schicht und eine Mittelung von mindestens zwei der Schicht-Messdatensätze jeweils mindestens einer Schicht oder eine Mittelung von aus den Schicht-Messdatensätzen jeweils einer Schicht rekonstruierten Bilddaten der jeweiligen Schicht umfasst.

12. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') mit einer Multi-Band-RF-Pulseinheit (7a), wobei die Steuereinrichtung (9) dazu ausgebildet ist, ein Verfahren nach einem der Ansprüche 1 bis 11 auf der Magnetresonanzanlage (1) auszuführen.

13. Computerprogrammprodukt, welches ein Programm umfasst und direkt in einen Speicher einer Steuereinrichtung (9) einer Magnetresonanzanlage (1) ladbar ist, mit Programm-Mitteln, um die Schritte des Verfahrens nach einem der Ansprüche 1 bis 11 auszuführen, wenn das Programm in der Steuereinrichtung (9) der Magnetresonanzanlage (1) ausgeführt wird.

14. Elektronisch lesbarer Datenträger mit darauf gespeicherten elektronisch lesbaren Steuerinformationen, welche zumindest ein Computerprogramm nach Anspruch 13 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 11 durchführen.

FIG 1

# FIG 2

101

102

$\Phi_1$

103     MD$_1$

104

$\Phi_i$

105     MD$_i$

106

107     gzMD

n

y

108

CD$_1$     CD$_2$

CD

CD$_i$

109

SMD

BD     110

S1
S2
Sn

Seq

# FIG 3

i=1

i=2

# FIG 4

# FIG 5

**Europäisches Patentamt**
**European Patent Office**
**Office européen des brevets**

# EUROPÄISCHER RECHERCHENBERICHT

Nummer der Anmeldung

EP 17 17 4507

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2016/036006 A1 (SAMSUNG ELECTRONICS CO LTD [KR]) 10. März 2016 (2016-03-10) * Absätze [0033], [0035], [0112], [0170] - [0181]; Abbildungen 3,6A,6B,9A,9B * ----- | 1-14 | INV. G01R33/483 G01R33/561 |

**RECHERCHIERTE SACHGEBIETE (IPC)**

G01R
G01N
A61B

Der vorliegende Recherchenbericht wurde für alle Patentansprüche erstellt

| Recherchenort | Abschlußdatum der Recherche | Prüfer |
|---|---|---|
| München | 31. Januar 2018 | Lebar, Andrija |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 17 17 4507

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-01-2018

| Im Recherchenbericht angeführtes Patentdokument | Datum der Veröffentlichung | Mitglied(er) der Patentfamilie | Datum der Veröffentlichung |
|---|---|---|---|
| WO 2016036006 A1 | 10-03-2016 | EP 3188661 A1<br>KR 20160029586 A<br>US 2016069974 A1<br>WO 2016036006 A1 | 12-07-2017<br>15-03-2016<br>10-03-2016<br>10-03-2016 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

**In der Beschreibung aufgeführte Patentdokumente**

- DE 102016218955

- US 15262233 B

**In der Beschreibung aufgeführte Nicht-Patentliteratur**

- **VON BREUER et al.** Controlled Aliasing in Parallel Imaging Results in Higher Acceleration (CAIPIRINHA) for Multi-Slice Imaging. *Magnetic Resonance in Medicine,* 2005, vol. 53, 684-691
- **VON SETSOMPOP et al.** Blipped-Controlled Aliasing in Parallel Imaging for Simultaneous Multislice Echo Planar Imaging With Reduced g-Factor Penalty. *Magnetic Resonance in Medicine,* 2012, vol. 67, 1210-1224

- **VON ZAHNEISEN et al.** Three-Dimensional Fourier Encoding of Simultaneously Excited Slices: Generalized Acquisition and Reconstruction Framework. *Magn. Reson. Med.,* 2014, vol. 71, 2071-2081